# EUROPEAN PATENT APPLICATION

(11) **EP 1 199 908 A1**
(43) Date of publication of application: **24.04.2002**
(21) Application number: 00952002.4
(22) Date of filing: 14.08.2000
(51) Int. Cl.: H05B 3/20, H05B 3/10

(54) **CERAMIC HEATER**

(30) Priority: 22.10.1999 JP 30088099; 26.11.1999 JP 33564099; 11.01.2000 JP 2000002870
(71) Applicant: Ibiden Co., Ltd., Ibi-gun, Gifu 501-0601 (JP)
(72) Inventor: ITO, Yasutaka, c/o Ibiden Co Ltd, Ibi-gun, Gifu 501-0601 (JP)
(74) Representative: Hogg, Jeffery Keith
(86) International application number: JP0005462
(87) International publication number: WO0131978

(57) **Abstract**

To provide a ceramic heater which is excellent in the temperature uniformity by using a ceramic material having a high heat-conductivity as a heater substrate.

A disk-shaped ceramic heater 100 is constructed such that, on or inside a ceramic substrate 1, a heat generation body pattern 2 having a bending pattern which describes an arc is formed so that the pattern width is approximately uniform.

## Description

### TECHNICAL FIELD

The present invention relates to a ceramic heater, which is used principally in an industrial field of semiconductors. More particularly, the present invention relates to a ceramic heater for heating, which has a heat generation body pattern capable of preventing formation of a specific spot of low temperature.

### BACKGROUND ART

Applied semiconductor products are indispensable in many industrial fields. As a typical example, semiconductor chips are manufactured by slicing a silicon monocrystalline to a predetermined thickness to produce a silicon wafer and then forming a variety of circuits.

To form such various circuits, firstly, components such as conductive thin films are formed on the silicon wafers, and then etching resist made of photoresistive resin is applied thereto through a mask having a circuit pattern thereby to carry out pattern etching. Upon applying the etching resist, the silicon wafer needs drying after applying the photoresistive resin because of the viscosity of the photoresistive resin. Therefore, the silicon wafer which has been applied photoresistive resin is placed on the ceramic heater for carrying out the heating and drying and hardening treatment. Also, the silicon wafer needs heating upon plasma etching or sputtering.

This type of heater used for placing a semiconductor wafer such as a silicon wafer thereon for the heating and drying treatment, conventionally, one having a heat generation body such as an electrical resistive body mounted to a rear face of an aluminum heater substrate has been mainly used. The aluminum heater substrate, however, needs to be approximately 15 mm in thickness, and thus is heavy and bulky. For this reason, the aluminum heater substrate is not easy to handle. In addition, since the heating is achieved by electric resistive body, it is insufficient in temperature control ability in view of temperature responsiveness to current supply, which makes it difficult to achieve uniform heating.

To overcome the above problems, in Japanese patent publication Laid-open No. 11(1999)-40330(A), a ceramic heater is disclosed which has a ribbon-like heat generation body formed by sintering metal particles or the like on the surface of a plate made of ceramic nitride or the like.

However, upon forming a heat generation body on such a ceramic heater, if the heat generation body is formed into a pattern having the bending portions, then a temperature of the bending portion lowers. This causes a problem of non-uniformity in the surface temperature, and thus, it is needed that further improvement on such a ceramic heater.

Non-uniformity in the surface temperature as described above is more noticeable in a ceramic nitride material having a high heat-conductivity.

The object of the present invention is to provide a ceramic heater which is excellent in the temperature uniformity by using a ceramic material having a high heat-conductivity as a heater substrate.

### DISCLOSURE OF INVENTION

In order to solve the above-mentioned problem, a ceramic heater according to claim 1 consistent with the present invention comprises a disk-shaped ceramic substrate which has a heat generation body pattern formed on a surface thereof, wherein the ceramic substrate is made of at least one selected from the group consisting of aluminum nitride and ceramic carbide; the heat generation body pattern has a bending portion which describes an arc.

A ceramic heater according to claim 2 consistent with the present invention comprises a disk-shaped ceramic substrate which has a heat generation body pattern formed inside thereof, wherein the ceramic substrate is made of at least one selected from the group consisting of aluminum nitride and ceramic carbide; the heat generation body pattern is united with the ceramic substrate; and the heat generation body pattern has a bending portion which describes an arc.

A ceramic heater according to claim 3 consistent with the present invention comprises a disk-shaped ceramic substrate which has a heat generation body pattern formed on a surface thereof, wherein the heat generation body pattern has a bending portion which describes an arc having a curvature radius within a range of 0.1 to 20 mm.

A ceramic heater according to claim 4 consistent with the present invention comprises a disk-shaped ceramic substrate which has a heat generation body pattern formed inside thereof, wherein the heat generation body pattern has a bending portion which describes an arc having a curvature radius within a range of 0.1 to 20 mm.

The above-described constitution eliminates lowering of a temperature at the bending portions of the arrangement pattern of the heat generation body (also referred to as "heat generation body pattern"). In the case where a bending portion does not describe an arc, for example, in the case where the portion has a curved shape at right angle, a temperature at the right angle portion inevitably lowers. In the following description, the heat generation body pattern is described its shape in terms of a top view. The heat generation body, however, does not necessarily have to be arranged on the same plane relative to a direction of thickness of the ceramic substrate. Instead, the heat generation body pattern may include a portion where the heat generation body is arranged vertically in a direction of thickness.

The present inventors have made special studies for overcoming such problems. As a result, the inventors come to find the following cause.

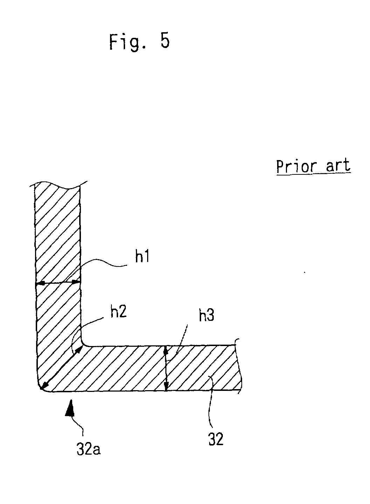

Fig. 5 is a view showing a heat generation body 32 which has been used for a conventional ceramic heater. Part of the heat generation body 32 has a curved shape at right angle. The temperature of the right-angle bending pattern (indicated by an arrow 32a) is low relative to the temperature of the other portions. The cause is that the pattern widths h1 and h3 of approximately linear portions differ from a pattern width h2 of the right-angle bending portion. In the case shown in Fig. 5, the pattern width h2 is greater than the pattern widths h1 and h3. This fact causes that a resistance value at the portion of the pattern width h2 is smaller. As a result, a specific point (spot) where a temperature is low is formed at the bending portion.

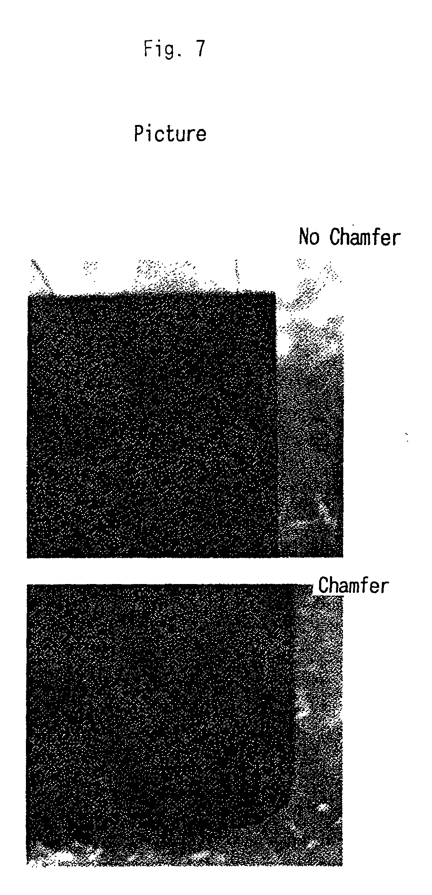

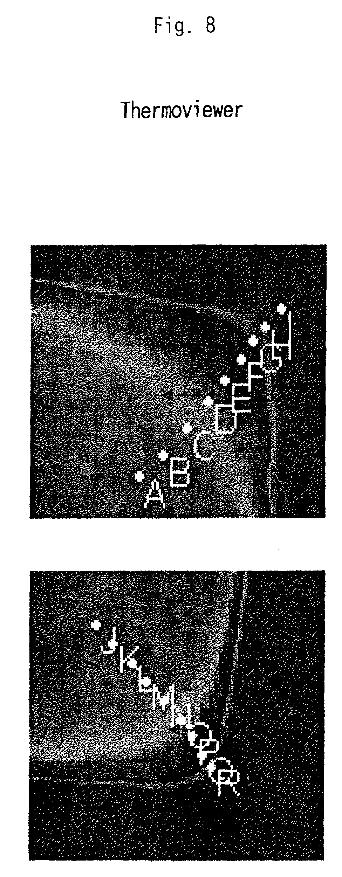

Especially, in the case of a disk-shaped ceramic heater, different from a square-shaped ceramic heater, uniformity in the temperature distribution is required. In the case of a square-shaped ceramic heater, a temperature is inevitably lowered on the surface at four corners due to the fact that heat conducts concentrically. Thus, uniformity in the temperature distribution is not required from the beginning. This fact is obvious from Fig. 7 and Fig. 8. Fig. 7 shows a square-shaped ceramic heater. Fig. 8 is an observation view by using a thermoviewer, showing a heating surface of a subject material to be heated, such as a wafer and the like, and the observation view is obtained by heating it up to 400 °C. As a result, each temperature at the four corners is low. This fact indicates that uniformity of the temperature distribution is such property that is not required from the beginning. On the other hand, in the case of the disk-shaped ceramic heater, it is possible to make the temperature distribution uniform. Therefore, it is required to achieve uniformity in the temperature distribution, which is an important factor to make the ceramic heater suitable for placing a semiconductor wafer thereon. Accordingly, in the case of such a disk-shaped ceramic heater, it is required to prevent forming a specific point (spot) of a low temperature.

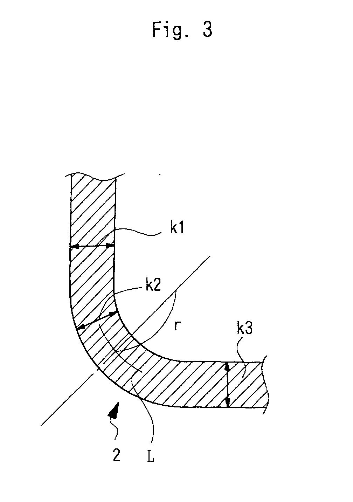

The present inventors have completed the present invention based on the finding that if an arrangement pattern of the heat generation body has a bending portion which describes an arc, as shown in Fig. 3, then the pattern widths can be generally equal to each other (k1 = k2 = k3). As the result, the resistance value at the bending portion can be prevented from being decreased, and consequently formation of a specific point (spot) of a low temperature can be prevented.

The ceramic heater constructed as above has the bending portion of the heat generation body pattern which describes an arc so that the pattern width is generally constant. As a result, occurrence of localized temperature decrease is prevented. It is realized that the temperature uniformity in the ceramic heater.

On the other hand, there is disclosed such square-shaped ceramic heater that has a bending portion which describes an arc in Japanese patent publication laid-open No. 9-289075 (A), Japanese utility model publication laid-open No. 3-19292 (A) and Japanese utility model publication laid-open No. 54-128945 (A). Disclosed in these publications, however, are not a disk-shape, thus different from the present invention. Additionally, in Japanese patent publication laid-open No. 9-82786 discloses such heater that has a space formed between a heat generation body bulk and a ceramic substrate, but its construction is different from the present invention. Because, in the case of the present invention, the ceramic substrate is united with a heat generation body. Therefore, heat is not conducted in the space, thus a temperature of a heating surface can not be uniform in this case, different from the present invention. Additionally, in Japanese patent publication No. 53-6936 (A), such electric instrument is disclosed that is provided with a heat generation body on one surface of the ceramic heat plate. This instrument, however, is applied for a microwave oven and an electric heater. Under the consideration of the influence to human and reactivity of ceramic, material of the instrument is limited to such material as to be impervious to water and to be innoxious, namely, the material is limited to ceramic oxide, such as alumina, silica. It is obvious that ceramic nitride and ceramic oxide can not be applied for the instrument although they can be applied for the present invention. ceramic oxide is not excellent in the temperature responsiveness (it takes time to make a temperature rise even if it is heated).

In addition, there is no citation and no suggestion with respect to a curvature radius, thus patentability of the present invention is not denied by the above-identified publications.

In addition, the ceramic heater consistent with the present invention may be used within a temperature range from 150 to 800 °C in agreement with each use.

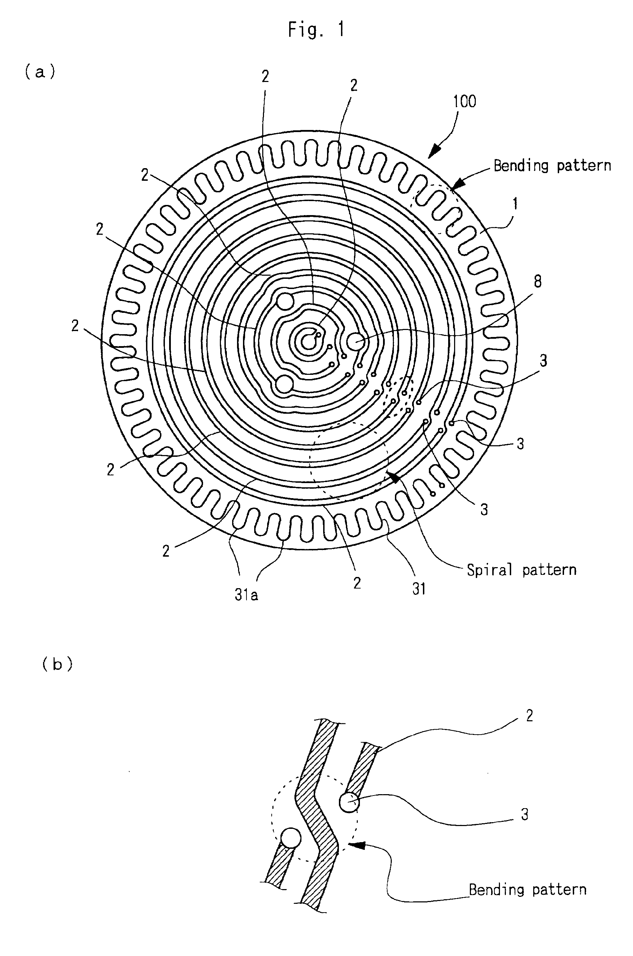

In the present invention, the meanings of "bending" involves following cases: the first case is that patterns are approximately parallel to each other before and after the bending portion of the heater generation body pattern as shown in Fig. 1(b); and the second case is that patterns form a right angle, an acute angle or an obtuse angle respectively before and after the bending portion of the heater generation body pattern. Comparing these two cases, the latter case has higher tendency for a temperature to fall than that of the former case. Therefore, the present invention is more effective for the latter case than the former case.

### BRIEF DESCRIPTION OF THE DRAWINGS

Fig. 1(a) is a plan view showing a main portion of a ceramic heater consistent with one embodiment of the present invention, and Fig. 1(b) is an enlarged fragmentary view showing a portion enclosed in a dotted oval in Fig. 1(a).
Fig. 2 is a plan view showing a heat generation body pattern of the ceramic heater consistent with the embodiment of the present invention.
Fig. 3 is an enlarged fragmentary view showing a portion of the heat generation body pattern of the ceramic heater consistent with the embodiment of the present invention.
Fig. 4 is a sectional fragmentary view showing a portion of a structure of the ceramic heater consistent with the embodiment of the present invention.
Fig. 5 is an enlarged fragmentary view showing a portion of a heat generation body pattern of a conventional ceramic heater.
Fig. 6 is a plan view showing a main portion of a ceramic heater used as a comparative example.
Fig. 7 is a picture substituted for a figure showing a square-shaped ceramic heater.
Fig. 8 is a picture substituted for a figure showing a thermoviewer.
Figs. 9 (a) and 9 (b) are sectional views showing a constitution where a heater is formed inside in one united body.

### THE BEST MODE FOR CARRYING OUT THE INVENTION

One preferred embodiment consistent with the present invention will be now described below in greater details with reference to accompanying drawings.

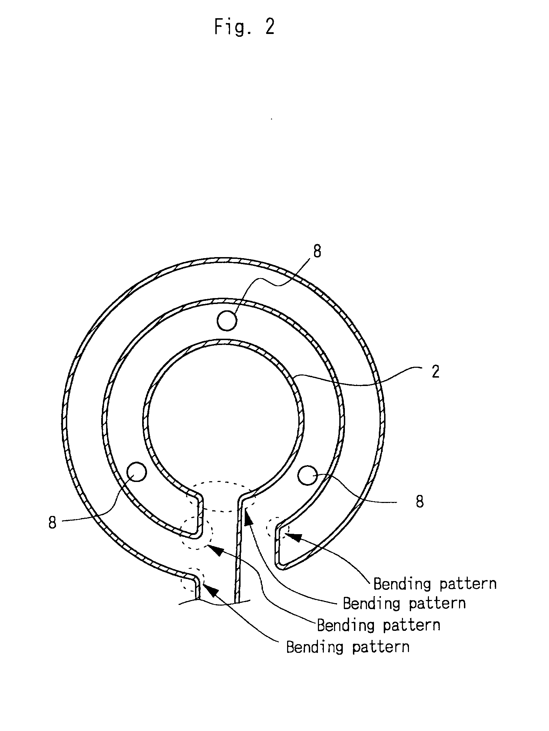

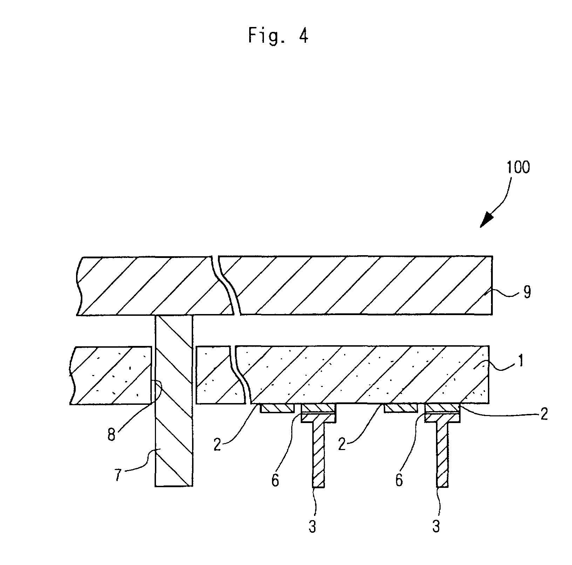

Fig. 1(a) is a plan view showing a main portion of a ceramic heater 100, and Fig. 1(b) is a view showing a portion enclosed in a dotted oval in Fig. 1(a) in enlarged dimension. Fig. 2 is a view showing a heat generation body pattern arranged on the ceramic heater 100 in enlarged dimension. Fig. 3 is a view showing a portion of a heat generation body pattern in enlarged dimension. Fig. 4 is a sectional fragmentary view showing a structure of the ceramic heater 100.

In these figures, the ceramic heater 100 comprises a plate-shaped ceramic substrate 1 made of insulating material, such as ceramic nitride or ceramic carbide. The ceramic heater 100 is constructed as following so that a silicon wafer or the like may be heated: on a principal plain of the ceramic heater 100, as shown in Fig. 1, there is formed a heat generation body pattern 2 which has a predetermined width and a flat cross section; another principal plane of the ceramic heater 100 is for placing a silicon wafer or the like.

The heat generation body pattern is formed with generally straight or curved lines, which are a shape of lines or a shape of ribbon-shaped lines having a certain width. A cross section of the heat generation body is not limited to any specific type as long as the cross section has a flat shape including a rectangle, an ellipsis or the like. It is also applicable that the line-shaped heat generation body is formed spirally.
An aspect ratio (a width of the heat generation body /a thickness of the heat generation body) for the cross section of the heat generation body pattern 2 may preferably be within a range of 10 to 5000. Because the resistance value of the heat generation body pattern 2 can be increased and the uniformity in the temperature on the heating surface can be ensured by adjusting the ratio within the range.

Assuming the thickness for the heat generation body pattern 2 is constant, if the aspect ratio is smaller than the above-mentioned range, then the amount of heat conduction in the wafer heating direction of the ceramic substrate 1 is reduced and a heat distribution similar to the pattern of the heat generation body pattern 2 is undesirably generated on the heating surface. On the other hand, if the aspect ratio is too large, then the temperature of the heating surface corresponding to a portion just above the central part of the heat generation body pattern 2 is elevated to be high and, after all, a heat distribution similar to the pattern of the heat generation body pattern 2 is generated on the heating surface. Accordingly, considering the temperature distribution, the aspect ratio for the cross section may preferably be within a range of 10 to 5000.

When the heat generation body pattern 2 is formed on the surface of the ceramic substrate 1, the heat generation body pattern 2 preferably has a thickness of 1 to 30 µm, and more preferably has a thickness of 1 to 10 µm. Alternatively, when the heat generation body pattern 2 is formed inside the ceramic substrate 1, the thickness thereof is preferably 1 to 50 µm. In addition, when the heat generation body pattern 2 is formed on the surface of the ceramic substrate 1, the heat generation body pattern 2 preferably has a width of 0.1 to 20 mm, and more preferably has a width of 0.1 to 5 mm. Alternatively, when the heat generation body pattern 2 is formed inside the ceramic substrate 1, the width of the heat generation body pattern 2 is preferably 5 to 20 µm.

The heat generation body pattern 2 shown in Fig. 1 is a combination of a spiral pattern and a bending pattern, and it is preferred that the bending pattern is arranged along the outer regions. This is because the bending pattern is suitable to make the pattern density high so that temperature decrease along the outer region is suppressed despite the fact that the temperature thereof tends to be low. Alternatively, the heat generation body pattern 2 may be formed only with a bending pattern as shown in Fig. 2.

The heat generation body pattern 2 shown in Figs. 1 and 2 has a predetermined width, as shown in Fig. 3 which shows a portion thereof. Accordingly, the heat generation body pattern 2 is constituted such that pattern widths k1, k2 and k3 are equal to each other (k1 = k2 = k3), and that the bending portion has a curvature radius γ. Therefore, the heat generation body pattern 2 has a constitution capable of preventing the resistance value from being decreased, and hence preventing formation of a specific point (spot) of a low temperature caused by the decrease of the resistance value.

Here, said ceramic substrate preferably be of a sintered aluminum nitride material. Although, the material used for the ceramic substrate is not limited to aluminum nitride, indeed ceramic carbide, ceramic oxide, ceramic nitride other than aluminum nitride, and the like may also be preferred.

Some examples of ceramic carbide include the metal ceramic carbide materials, such as silicon carbide, zirconium carbide, titanium carbide, tantalum carbide and tungsten carbide. Some examples of ceramic oxide include the metal ceramic oxide materials such as alumina, zirconia, cordierite and mullite. Further, some examples of ceramic nitride include the metal ceramic nitride materials, besides aluminum nitride, such as silicon nitride, boron nitride, titanium nitride.

Among these ceramic materials, in general, ceramic nitride and ceramic carbide are preferred to ceramic oxide in that the former materials exhibit higher heat conductivity. Here, these materials may be used alone or in combination of two or more materials.

For example, ceramic oxide and/or ceramic carbide may be added to ceramic nitride, alternatively, ceramic oxide and/or ceramic carbide may be added to ceramic carbide.

A decrease in temperature of a bending portion is more remarkable in such a ceramic substrate that has a high heat conductivity. Also, the present invention is more effective on such a ceramic substrate.

The ceramic substrate of the present invention may preferably be of a thickness less than or equal to 50 mm, more preferably be of a thickness less than or equal to 18 mm. Because if a thickness is more than 18 mm, a heat capacity is increased. Particularly, if a temperature control means is provided for the ceramic substrate thereby the heating and cooling is repeated, the temperature responsiveness is lowered due to a heat capacity.

In addition, in the case of a ceramic substrate having a thickness more than 18 mm, such a problem of non-uniformity of temperature, solved by the present invention, is difficult to occur. Particularly, a thickness may preferably be of less than or equal to 50 mm. Yet, a thickness may preferably be of more than or equal to 1 mm.

The ceramic substrate of the present invention may preferably be of a diameter more than or equal to 200 mm. Particularly, a diameter may preferably be of more than or equal to 12 inch (300 mm). In the next generation, such size is considered as the main current of the silicon wafer technology. Additionally, the problem of non-uniformity of temperature, solved by the present invention, is difficult to occur, in the case of a ceramic substrate having a diameter less than or equal to 200 mm.

The ceramic substrate of the present invention may preferably dope 5 to 5000 ppm of carbon. By doping carbon, the ceramic substrate can be made to be black, thereby the radiant heat can be utilized sufficiently when used as a ceramic heater.

Carbon may be of non-crystalline or crystalline. In the case of non-crystalline carbon, a fall of a volume resistance under a high temperature can be prevented. In the case of crystalline carbon, a fall of a heat conductivity under a high temperature can be prevented. Therefore, in some case, both crystalline carbon and non-crystalline carbon may be used at the same time. A dope amount may preferably be of 50 to 2000 ppm.

In the case that the ceramic substrate is doped with carbon, carbon may be doped so that brightness standardized by the rule of Japanese Industry Standard (JIS) Z 8721 is less than or equal to N4. The ceramic substrate having such brightness is excellent in radiation heat and concealment performance. Here, brightness N is defined as 0 for ideal black, 10 for ideal white. Thereby brightness between black and white is divided by 10 grades so that recognition of each brightness of the color may be equal step. Each brightness is indicated by N0 to N10.

Actual measurement of brightness is performed by way of comparing color targets corresponding to N0 to N10 respectively. In this case, a value of one place of decimals is defined as 0 or 5.

In addition, the ceramic substrate of the present invention may be constructed such that a silicon wafer is made to be placed on and contacted to a wafer-positioning surface. Other than this construction, the ceramic substrate of the present invention may alternatively be constructed such that a silicon wafer is made to be held by means of a hold pin with keeping a predetermined space between the ceramic substrate, as shown in Fig. 4.

In Fig. 4, a silicon wafer 9 is held by inserting a hold pin 7 to a through-hole 8. By making the hold pin 7 slide upward and downward, the silicon wafer 9 carried from a carrier system can be received and placed on the ceramic substrate, or can be heated with being held by unillustrated pin. In addition, a heat generation body 2 is formed on a bottom surface of the ceramic substrate, and the generation body 2 is coated with a metal coating layer. Furthermore, there is provided with a hole with a bottom, into which a thermo-couple is inserted.

In this construction, the heat generation body is formed on a surface of the ceramic substrate, therefore, a resistance value may be adjusted, or, cooled gases may be sprayed when cooling. Thereby, rapid cooling can be realized.

In addition, all regions of the ceramic substrate in a thickness direction can be used as a heat diffusion plate. Thus, the ceramic substrate can be thinner than the case that a heat generation is formed inside. Thereby, a heat capacity can be made to be low, and, rapid heating and cooling can be realized. The silicon wafer 9 is heated on a wafer heating surface opposite to a position where the heat generation body is formed.

Next, description is given to a method of manufacturing the ceramic heater 100 consistent with the present invention. In the following description, the process conditions are presented by way of example and not limited to this embodiment. Accordingly, the process conditions are set with adequate changes depending on a sample size, amount of process and the like.

First, a composition comprising 100 parts by weight of an aluminum nitride powder (average grain size: 1.1 µm), 4 parts by weight of yttria (average grain size: 0.4 µm), 12 parts by weight of an acrylic resin binder and alcohol was mixed and kneaded, and then spray dried to prepare a granular powder.

In the case of adopting silicon carbide, a composition comprising 100 parts by weight of a silicon carbide powder (average grain size: 1.0 µm), 0.5 parts by weight of C or B4C, 12 parts by weight of an acrylic resin binder and alcohol was mixed and kneaded, and then spray dried to prepare a granular powder.

In addition, in the case of adopting alumina as the below-mentioned reference examples, a composition comprising an alumina powder (average grain size: 1.0 µm), 12 parts by weight of an acrylic resin binder and alcohol was mixed and kneaded, and then spray dried to prepare a granular powder.

Next, the granular powder was placed in a molding die, and molded into a flat plate to obtain a green molding product. Drilling was applied to the green molding product to form through-holes for inserting support pins of a semiconductor wafer and recesses for burying thermocouples.

The green molding product having through-holes and recesses formed therethrough was hot pressed at 1800 °C, under a pressure of 200 kg/cm² to obtain a plate-like sintered aluminum nitride or silicon carbide body having 3 mm thickness. A disk of 210 mm diameter was cut out of the plate to prepare the ceramic substrate 1 of the ceramic heater 100.

Then, a surface of the ceramic substrate may be coated with an insulating film, such as an oxide film, after that, a below-mentioned heat generation body may be printed thereon.

More definitely, following method can be adopted upon coating an insulation film: one method is a melting method having steps of coating a glass paste thereon and then heating above 1000 °C; another method is a sintering method at a temperature of 500 to 1000 °C in an oxidation atmosphere.

Particularly, in the case of ceramic carbide, if a purity is low, then it shows electric conductivity, therefore, an insulating film may be formed thereon.

The insulating film may be of a thickness within a range of 0.1 to 1000 µm.

A conductor paste was printed by screen printing on the obtained ceramic substrate 1 so as to form the heat generation body pattern 2 as shown in Fig. 1. The conductor paste used herein was SILVEST PS603D (trade name) manufactured by TOKURIKI CHEMICAL RESEARCH CO., LTD. The conductor paste was so-called a silver-lead paste and contained 7.5 parts by weight of metal oxide containing a mixture of lead oxide, zinc oxide, silica, boron oxide and alumina (the weight ratios, in the same order, were 5/55/10/25/10) in relation to an amount of silver. The silver grains mainly had an average grain size of 4.5 µm in a scaled state.

The ceramic substrate printed with the conductor paste in the above manner was heated and sintered at 780 °C to sinter silver and lead contained in the conductor paste and bake them to the ceramic substrate. Here, the heat generation body pattern made of the silver-lead sintered body had approximately 5 µm thickness, 2.4 mm width and 7.7 mΩ/□ sheet resistivity. The heat generation body pattern had a bending pattern which describes an arc, arranged along the outer regions. The curvature radius may preferably be within a range of 0.1 to 20 mm. If the radius is too small, the bending portion is bent at a right angle, on the other hand, if it is too large, the heat generation body pattern may not be dense. Here, the curvature radius is defined by a center line of the heat generation body (indicated by a reference L in Fig. 3).

Next, the ceramic substrate was immersed in an electroless nickel plating bath comprising aqueous solutions at concentrations of 80 g/l of nickel sulfate, 24 g/l of sodium phosphate, 12 g/l of sodium acetate, 8 g/l of boric acid and 6 g/l of ammonium chloride in order to deposit a metal coating layer of nickel having 1 µm thickness on the surface of the silver-lead sintered body thereby forming a heat generation body pattern.

As shown in Fig. 1(a), to obtain the heat generation body pattern 2, 31 and 31a, a predetermined pattern shown in the figure was formed on the ceramic substrate 1, and then the pattern was sintered to an extent that metal particles and metal oxide particles were fused to each other. Here, the heat generation body patterns do not have to be formed with strictly geometrical straight or curved lines as long as they are of generally straight or curved lines having certain widths, as shown in Fig. 1(b).

In the end, as shown in Fig. 4, a silver-lead solder paste (manufactured by Tanaka Kikinzoku Kogyo K.K.) was printed by screen printing onto portions for attaching terminal-pins 3 for attaining connection between the heat generation body pattern 2 and a power source so as to form a solder layer 6. Then, the terminal-pins 3 made of Kovar were placed on the solder layer, put to reflow under heating at 420 °C and the terminal-pins 3 were attached to the surface of the heat generation body pattern 2.

In addition, thermocouples (not illustrated) for temperature control were berried into the ceramic substrate 1 to obtain the ceramic heater 100 consistent with present invention. In Fig. 4, reference numeral 7 denotes a support pin for supporting a semiconductor wafer 9, and the figure illustrates that the support pin 7 is inserted into a through-hole 8 formed through the ceramic substrate 1. Since the heat generation body pattern 2 had a predetermined resistance value, the heat generation body pattern 2 was supplied current from positions at which the terminal-pins 3 for supplying current were fixed. The heat generation body pattern 2 then generated heat by Joule heat thereby heating the semiconductor wafer 9.

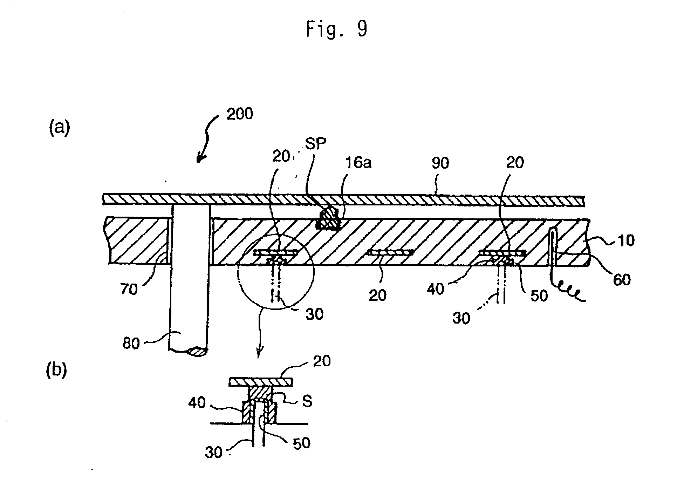

Furthermore, a method for manufacturing a ceramic heater in which a heat generation body is formed therein (Fig. 9) will be described hereinbelow.
(1) Firstly, a ceramic powder, such as ceramic nitride or ceramic carbide, binder and solvent were mixed to prepare a green sheet.
   For the ceramic powder, for example, aluminum nitride may be used, in case of need, sintering agent, such as yttria and the like may be added. Concentration of the sintering agent may be adjusted so as to be within a range of 0.1 to 10 wt %. A mean particle diameter of ceramic powder is within a range of 0.1 to 10 µm.
   For the binder, at least one selected from a group consisted of acrylic binder, ethyl cellulose, butylcellosorb and polyvinyl alcohol is preferred.
   For the solvent, at least one selected from a group consisted of α-terpineol and glycol is preferred.
   Then, paste obtained by mixing these materials is formed into a sheet-like shape to prepare a green sheet. The green sheet may alternatively be produced by using alumina powder under the same condition.
   On the green sheet, a through-hole for inserting a support pin of silicon wafer and/or a recess for burying a thermocouple may be formed in case of need. The through-hole and the recess may be formed by punching.
   A thickness of the green sheet may preferably be within a range of 0.1 to 5 mm.
   Next, the green sheet was printed with a conductive paste which is to be a resistive heat-generation body. The printing is performed so as to obtain a desired aspect ratio in consideration of a percentage of contraction of the green sheet.
   For conductive ceramic particles contained in these conductive paste, tungsten carbide or molybdenum carbide will be preferred because these materials are not only readily subject to be oxidized but also to be decreased thermal conductivity.
   As the metal particles, for example, any of tungsten, molybdenum, platinum, nickel, and the like may be used.
   A mean particle diameter of these conductive ceramic particles and these metal particles may be within the range of 0.1 to 5 µm. Because, if these particles are too large or too small, then it becomes difficult to print the conductive paste.
   For the above-mentioned paste, it is the most suitable paste that is prepared by mixing 85 to 97 parts by weight of metal particles or conductive ceramic material, 1.5 to 10 parts by weight of at least one binder selected from a group consisted of acrylic type, ethyl cellulose, butylcellosorb and polyvinyl alcohol, 1.5 to 10 parts by weight of at least one solvent selected from a group consisted of α-terpineol, glycol, ethyl alcohol and butanol.
   Furthermore, the through-hole printed body is obtained by filling a punched-hole with the conductive paste.
   Next, the green sheet having a printed-body and the green sheet having no printed-body are laminated in order. The green sheet having no printed-body is laminated on the side where the resistive heat-generation body is formed. The reason is to prevent an end face of the through-hole from being oxidized at the time of sintering for forming the resistive heat generation body, caused by exposure of the end face. If sintering for forming the resistive heat generation body is carried out under the state that the end face of the through-hole is exposed, then the metals not subject to be oxidized, such as nickel, should be sputtered. More preferably, a gold solder of Au-Ni may be coated thereon.
(2) Next, the laminated body is heated and pressured, thereby the green sheet and the conductive paste are sintered in a body.
   A heating temperature may preferably be within a range of 1000 to 2000 °C and a pressure may preferably be within a range of 100 to 200 kg/cm². Heating and pressuring processes are carried out under an inert gas atmosphere. For the inert gas, Ar, N₂ and the like, may preferably be used.
(3) Next, a blind hole is formed, which is for connecting with an external pin. A part of an inside wall of the blind hole is made to be conductive. The inside wall which is made to be conductive may preferably be connected with a resistive heat generation body 5 and the like (Fig. 9(b)).
(4) In the end, an external terminal pin is provided for the blind hole with a gold solder. Furthermore, in case of need, a hole with a bottom may be formed, thereby a thermocouple may be buried therein.

For the solder, alloys, such as Ag-Pb, Pb-Sn, Bi-Sn and the like, may be used.

In addition, a thickness of solder layer may preferably be within a range of 0.1 to 50 µm. In such a range, connection by solder may be ensured sufficiently.

As described above, a ceramic heater 200 shown in Fig. 9(a) may be produced. The ceramic heater 200 is constructed such that a resistive heat generation body 20 is formed inside of the ceramic substrate 10 in one body with the ceramic substrate 10. And a circumference of the resistive heat generation body 20 is properly contacted with the ceramic substrate 10. Therefore, heat transmits uniformly. The wafer 9 is positioned in the side of the heating surface 10a of the ceramic substrate 10 in a manner of being placed directly thereon or in a manner of being spaced at a given distance (5 to 5000 µm) therebetween via a spacing-support pin SP. Under the state, the wafer 9 is heated. The heat generation body 20 is connected with the through-hole S. In addition, the through-hole S is connected with an inner wall 40 which is made to be conductive, furthermore, the inner wall 40 is connected with the pin 30 via a gold solder 50.

On the ceramic substrate, the through-hole 70 for inserting the support pin (lifter pin) 80 is formed.

### [Evaluation test]

Samples of Examples 1 to 8 were prepared as following: four kinds of heat generation patterns made of aluminum nitride and silicon carbide respectively were formed on the ceramic substrate, with varying respective curvatures of bending patterns. Samples of Examples 9 to 16 were prepared as following: four kinds of heat generation patterns made of the aluminum nitride ceramic and the silicon carbide ceramic respectively were formed inside the ceramic substrate, with varying respective curvatures of bending patterns.

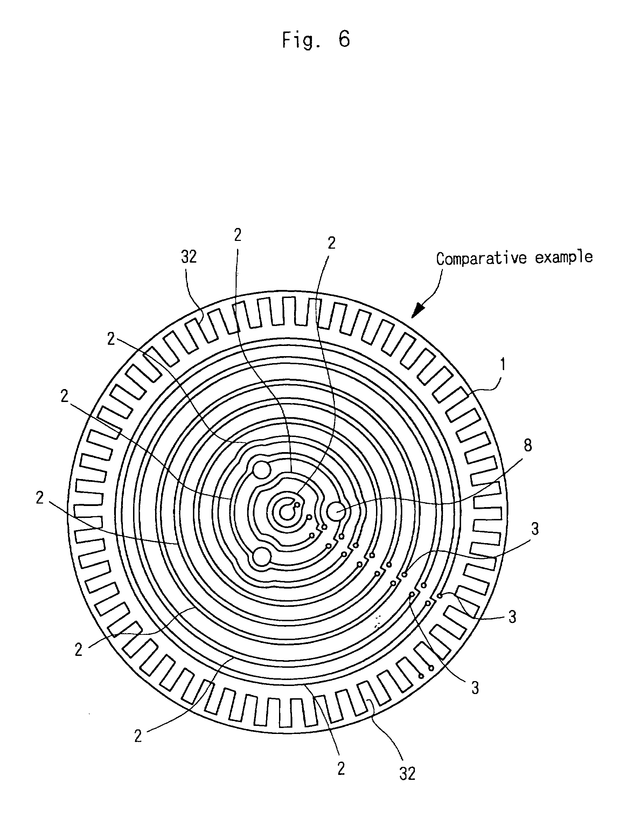

Samples of Comparative Examples 1 to 4 were prepared as following: heat generation patterns having a bending pattern of an approximate right angle as shown in Fig. 6, made of aluminum nitride and silicon carbide respectively, were formed on or inside the ceramic substrate. In addition, for other comparative examples, samples of Reference examples 1 to 4 were prepared as following: heat generation patterns having a pattern which describes an arc having a curvature radius of 25 mm, made of aluminum nitride and silicon carbide respectively, were formed on or inside the ceramic substrate. Furthermore, samples of Reference examples 5 to 16 were prepared as following: heat generation patterns made of alumina substrate, were formed on and/or inside the ceramic substrate.

Furthermore, samples of Comparative examples 5 and 6 were prepared as following: square-shaped ceramic heaters were produced by adopting aluminum nitride ceramic or silicon carbide ceramic as material, respectively (patterns were formed on all of them). After that, they were heated up to 300 °C, then each temperature difference between four corners and the center were measured.

In the evaluation test, Examples and Comparative examples were heated up to 300 °C under the application of voltage. After that, each temperature around the bending patterns and at a vicinity of the spiral patterns were measured with a thermocouples of JIS-C-1602 (1980) K type, based on which, each temperature difference therebetween was examined. In addition, each heating time up to 300 °C was measured. The results are shown in Table 1.

Furthermore, the ceramic heater was heated up to 200 °C, then was dropped into water to examine whether or not a crack would be developed at the bending portions.

**Table 1**

| | Ceramic | Heat generation body | Curvature radius | Temperature difference | Heating time | Crack |
|---|---|---|---|---|---|---|
| Example 1 | ALN | Surface | 1(mm) | 5(°C) | 45 sec. | No |
| Example 2 | ALN | Surface | 5(mm) | 3(°C) | 45 sec. | No |
| Example 3 | ALN | Surface | 10(mm) | 1(°C) | 40 sec. | No |
| Example 4 | ALN | Surface | 15(mm) | 1(°C) | 40 sec. | No |
| Comparative example 1 | ALN | Surface | 0(mm) | 10(°C) | 45 sec. | Yes |
| Comparative example 1 | ALN | Surface | 25(mm) | 8(°C) | 45 sec. | No |
| Example 5 | SiC | Surface | 1(mm) | 5(°C) | 55 sec. | No |
| Example 6 | SiC | Surface | 5(mm) | 4(°C) | 55 sec. | No |
| Example 7 | SiC | Surface | 10(mm) | 2(°C) | 50 sec. | No |
| Example 8 | SiC | Surface | 15(mm) | 2(°C) | 50 sec. | No |
| Comparative example 1 | SiC | Surface | 0(mm) | 15(°C) | 55 sec. | Yes |
| Comparative example 1 | SiC | Surface | 25(mm) | 9(°C) | 55 sec. | No |
| Example 9 | ALN | Inside | 1(mm) | 5(°C) | 50 sec. | No |
| Example 10 | ALN | Inside | 5(mm) | 4(°C) | 50 sec. | No |
| Example 11 | ALN | Inside | 10(mm) | 2(°C) | 45 sec. | No |
| Example 12 | ALN | Inside | 15(mn) | 2(°C) | 45 sec. | No |
| Comparative example 1 | ALN | Inside | 0(mm) | 12(°C) | 50 sec. | Yes |
| Comparative example 1 | ALN | Inside | 25(mm) | 9(°C) | 50 sec. | No |
| Example 13 | SiC | Inside | 1(mm) | 5(°C) | 45 sec. | No |
| Example 14 | SiC | Inside | 5(mm) | 3(°C) | 45 sec. | No |
| Example 15 | SiC | Inside | 10(mm) | 1(°C) | 40 sec. | No |
| Example 16 | SiC | Inside | 15(mm) | 1(°C) | 40 sec. | No |
| Comparative 4 example | SiC | Inside | 0(mm) | 12(°C) | 50 sec. | Yes |
| Reference example 4 | SiC | Inside | 25(mm) | 8(°C) | 50 sec. | No |
| Reference example 5 | Alumina | Surface | 0(mm) | 7(°C) | 15 sec. | Yes |
| Reference example 6 | Alumina | Surface | 1(mm) | 4(°C) | 10 min. | No |
| Reference example 7 | Alumina | Surface | 5(mm) | 4(°C) | 9 min. | No |
| Reference example 8 | Alumina | Surface | 10(mm) | 3(°C) | 9 min. | No |
| Reference example 9 | Alumina | Surface | 15(mm) | 4(°C) | 9 min. | No |
| Reference example 10 | Alumina | Surface | 25(mm) | 7(°C) | 15 min. | No |
| Reference example 11 | Alumina | Inside | 0(mm) | 7(°C) | 15 min. | Yes |
| Reference example 12 | Alumina | Inside | 1(mm) | 4(°C) | 10 min. | No |
| Reference example 13 | Alumina | Inside | 5(mm) | 4(°C) | 9 min. | No |
| Reference example 14 | Alumina | Inside | 10(mm) | 3(°C) | 9 min. | No |
| Reference example 15 | Alumina | Inside | 15(mm) | 4(°C) | 9 min. | No |
| Reference example 1 | Alumina | Inside | 25(mm) | 7(°C) | 15 min. | No |
| Comparative example 5 | ALH | Square | 5(mm) | 15(°C) | - | - |
| Comparative example 6 | ALN | Square | 5(mm) | 15(°C) | - | - |

As apparent from this result, in the case of the ceramic heaters consistent with the present invention, the temperature difference between the portion near the bending pattern describing an arc and the portion in vicinity of the spiral pattern was kept within 5 °C, while the ceramic heater being the comparative example resulted in the temperature difference of 10 to 15 °C between the portion near the bending pattern describing an arc and the portion in the vicinity of the spiral portion. Thereby, it was found that the ceramic heaters consistent with the present invention were capable of ensuring uniformity in the temperature of the ceramic heater substrate. According to this result, in the case of the ceramic heater having the above constitution, the optimal curvature radius is about 1 to 15 mm.

In addition, in Examples, no cracks were formed in thermal shock testing, while, in Comparative examples, cracks were formed.

Furthermore, following consideration is made. If a curvature radius is more than 20 mm, then a temperature difference is made to be large. Because, a density of pattern formation is made to be lowered. The effect of the present invention is remarkable in the case that a curvature radius is within a range of 0.1 to 20 mm. In addition, this effect is more remarkable with respect to aluminum nitride and silicon carbide than aluminum. Because, aluminum nitride and silicon carbide are more excellent in a temperature responsiveness (in other words, a heating time is short), in addition to this, these materials are more sensitive to dispersion of quantity of heat.

As described above, one embodiment of the present invention has been described, but the present invention is not limited to the above embodiment.

The ceramic heater consistent with the present invention may be formed as an electrostatic chuck if its ceramic substrate is provided with electrode buried therein. Also, the ceramic heater consistent with the present invention may be formed as a wafer prober if its ceramic substrate is provided with a conductor layer on the surface thereof and with electrodes buried therein.

The ceramic heater consistent with the present invention is made of mainly ceramic nitride and/or ceramic carbide, and has a disk-shaped ceramic substrate with the bending portions which describes an arc, formed on the surface thereof, so as to eliminate formation of low temperature portions and thus excellent in temperature uniformity. The present invention is especially suitable to a ceramic heater of a disk-shape.

## Claims

1. A ceramic heater comprising a disk-shaped ceramic substrate which has a heat generation body pattern formed on a surface thereof, wherein the ceramic substrate is made of at least one selected from the group consisting of aluminum nitride and ceramic carbide, the heat generation body pattern has a bending portion which describes an arc.

2. A ceramic heater comprising a disk-shaped ceramic substrate which has a heat generation body pattern formed inside thereof, wherein the ceramic substrate is made of at least one selected from the group consisting of aluminum nitride and ceramic carbide, the heat generation body pattern is united with the ceramic substrate, and the heat generation body pattern has a bending portion which describes an arc.

3. A ceramic heater comprising a disk-shaped ceramic substrate which has a heat generation body pattern formed on a surface thereof, wherein the heat generation body pattern has a bending portion which describes an arc having a curvature radius within a range of 0.1 to 20 mm.

4. A ceramic heater comprising a disk-shaped ceramic substrate which has a heat generation body pattern formed inside thereof, wherein the heat generation body pattern has a bending portion which describes an arc having a curvature radius within a range of 0.1 to 20 mm.
